## Europäisches Patentamt
## European Patent Office
## Office européen des brevets

(11) Publication number: **0 020 131**
**B1**

(12) **EUROPEAN PATENT SPECIFICATION**

(45) Date of publication of patent specification: **01.12.82**

(51) Int. Cl.³: **H 03 H 19/00**

(21) Application number: **80301758.1**

(22) Date of filing: **28.05.80**

(54) Switched-capacitor filter.

<table>
<tr><td>

(30) Priority: **28.05.79 JP 65828/79**

(43) Date of publication of application:
**10.12.80 Bulletin 80/25**

(45) Publication of the grant of the patent:
**01.12.82 Bulletin 82/48**

(84) Designated Contracting States:
**DE FR GB IT**

(56) References cited:
**EP - A - 0 012 393**
**FR - A - 2 316 698**
**US - A - 4 056 737**

**IEEE JOURNAL OF SOLID-STATE CIRCUITS, vol. SC—12, no. 6, December 1977, pages 609—616,**
**New York, U.S.A.**
**C.H. SEQUIN: "Antialiasing Inputs for Charge-Coupled Devices"**

</td><td>

(73) Proprietor: **FUJITSU LIMITED**
**1015, Kamikodanaka Nakahara-ku**
**Kawasaki-shi Kanagawa 211 (JP)**

(73) Proprietor: **Nippon Telegraph and Telephone Public Corporation**
**1-6 Uchisaiwai-cho, 1-chome Chiyoda-ku Tokyo 100 (JP)**

(72) Inventor: **Kato, Seiji**
**14-15, Chuohrinkan 3-chome**
**Yamato-shi Kanagawa 242 (JP)**
Inventor: **Ueno, Norio**
**540, Kosugi-cho 1-chome Nakahara-ku Kawasaki-shi Kanagawa 211 (JP)**
Inventor: **Kakuishi, Mitsuo**
**5-18, Sumiregaoka Kohoku-ku Yokohama-shi Kanagawa 223 (JP)**
Inventor: **Ito, Akihiko**
**3780, Suge Tama-ku Kawasaki-shi Kanagawa 214 (JP)**
Inventor: **Iwata, Atsushi**
**1-17-1, Kotesashi-cho Tokorozawa-shi Saitama 359 (JP)**

(74) Representative: **Abbott, Leonard Charles et al, GILL JENNINGS & EVERY 53/64 Chancery Lane London WC2A 1HN (GB)**

</td></tr>
</table>

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

(56) References cited:
IEEE JOURNAL OF SOLID-STATE CIRCUITS, vol.
SC—14, no. 1, February 1979, pages 172—173
New York, U.S.A.
H.J. PFLEIDERER et al.: "Antialiasing Filter with
an Improved S/N Ratio"

IEEE JOURNAL OF SOLID-STATE CIRCUITS, vol.
SC—12, no. 6, December 1977, pages
617—625
New York, U.S.A.
J.L. BERGER et al.: "Cancellation of Aliasing in
CCD Low-Pass Filters"

1978 IEEE INTERNATIONAL SOLID-STATE
CIRCUITS CONFERENCE, Digest of Technical
Papers, February 1978 Session VIII, 15th
February 1978 pages 82—83
New York, U.S.A.
D.J. ALLSTOT et al.: "Fully-integrated High-
Order NMOS Sampled-Data Ladder Filters"

## Switched-capacitor filter

The present invention relates to a switched-capacitor filter having, at its input stage, a prefilter.

Stimulated by progress in MOS (metal oxide semi-conductor) technology, considerable interest has recently arisen in the possibility of realizing filters by means of switched-capacitors, that is, the switched-capacitor filter (hereinafter often referred to by the abbreviation "SCF"). The major advantages of the SCF reside in the facts that only capacitors, operational amplifiers, and switches are needed, that nearly perfect switches can easily be built and, especially, that all resonant frequencies are determined exclusively by capacitance ratios. Therefore, the SCF is very useful in various kinds of electronic processing systems, for example, PCM (pulse code modulation) communication systems. In a PCM communication system, as will be explained hereinafter, a low-pass filter is one of the important electronic processing members. The low-pass filter operates in such a manner as to cut off signals having a frequency higher than 4 kHz and, accordingly, only voice signals can pass therethrough. In the PCM communications system, it is preferable to build the low-pass filter by means of the SCF.

Although the SCF has the above mentioned advantages, it also has the disadvantage that, generally, the SCF is driven through a sampling operation. The sampling frequency for achieving the sampling operation is, for example, 128 kHz. In this case, since the SCF processes successive sampled voice data synchronously with said sampling frequency, a so-called alias signal is generated therein. If the SCF receives a signal having the frequency of, for example, $(128+1)$ kHz, an undesired signal of 1 kHz appears as the alias signal in a base band signal. This signal of 1 kHz is not a true voice signal and, accordingly, it should be eliminated. Consequently, a prefilter is added to the SCF at its input stage, in order to suppress said signal of $(128+1)$ kHz. Generally, the prefilter should suppress signals of $[128 \times n \pm (0 \text{ through } 4)]$ kHz ($n=1, 2, 3 \dots$) and their respective neighbouring signals, where the frequency of (0 through 4) kHz corresponds to the base band frequency representing the voice signal. Thus, the prefilter is also called as an anti-alias filter. In conventional SCFs, the prefilter is built as a second order RC active filter which is comprised of an operational amplifier, capacitors and resistors. However, the second order RC active filter is not preferable as a prefilter from an economical point of view. This is because the active filter includes the operational amplifier which requires energizing power. That is, the power consumption is relatively large. This fact corresponds to the first uneconomical point of view. Further, the single chip IC (integrated circuit) for fabricating the SCF is partially occupied by the operational amplifier of the RC active filter. That is, a high density IC cannot be obtained due to the presence of the operational amplifier. This fact corresponds to the second uneconomical point of view. It should be understood that, in each PCM communication system, since there are several thousand communication channels, several thousand operational amplifiers must be incorporated in the ICs. Accordingly, the above-mentioned power consumption becomes extremely large and, also the above-mentioned high density IC cannot be expected.

It has been proposed for the input stage of filters using charge-coupled devices (CCDs) to use a low-pass transversal pre-filter on the same chip as the CCD, operated at four times the filter sampling frequency. See for example IEEE JOURNAL OF SOLID-STATE CIRCUITS, vol. SC—12, no.6, December 1977, pages 609—616, especially at page 612. In figure 5 of this reference, two summing wells (WA, WB) each store and sum four successive samples of the input signal; the CCD filter receives the summed outputs from the two summing wells alternately (See also U.S. Patent No.4056737 for more details.) However, this device does not have the economic advantage of switched capacitors.

In IEEE JOURNAL OF SOLID-STATE CIRCUITS, vol. SC—14 no. 1, February 1979, pages 172—173 it is suggested that anti-aliasing filters may be realized using for example CTDs (charge transfer devices) or switched capacitor networks. A schematic diagram, figure 1, illustrates a PCM filter with an anti-alias prefilter operating at 4 kHz. An anti-alias sampling filter using switched capacitors is disclosed in U.S. Patent No.4039979 (equivalent to French Patent No.2316698). The anti-aliasing is achieved by the summation of successive samples stored in an array of capacitors switched in parallel, as shown for example in figures 3 and 4.

According to the present invention, a switched capacitor filter device with, at its input, an anti-alias sampling prefilter which provides the succeeding stage of the filter with a summed signal at the end of each period of a predetermined length, the sampling prefilter in each period making and storing at least two samples at different times of an input signal and combining the stored samples to form the summed signal, the anti-alias sampling prefilter comprising a plurality of switched capacitors controlled by clock pulses for sampling the input signal and storing the samples, is characterized in that the input sampling prefilter comprises first and second switched capacitors, of substantially equal capacitance connected in series, and a third switched capacitor of substantially half the said capacitance connected in parallel with the first and second switched capacitors, the clock pulses driving the first switched capacitor in phase opposition to the second and third switched capacitors, and the second and third switched capacitors discharging simultaneously into the succeeding stage of the filter.

The present invention will be more apparent from the ensuing description with reference to the accompanying drawings, wherein:

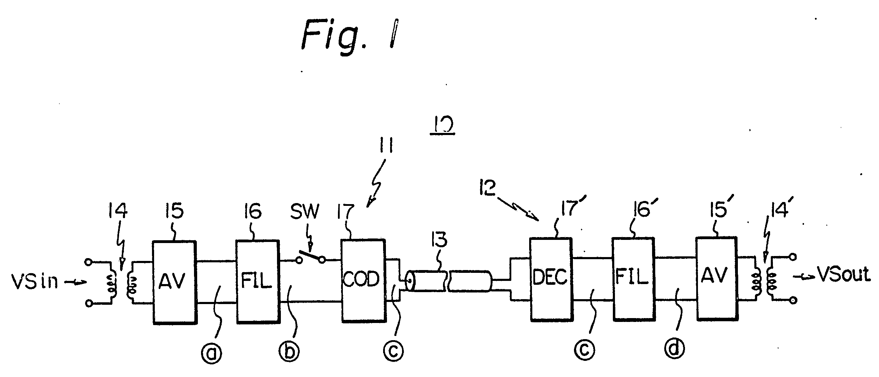

Fig. 1 is a schematic view illustrating a conventional PCM communication system which may incorporate an SCF;

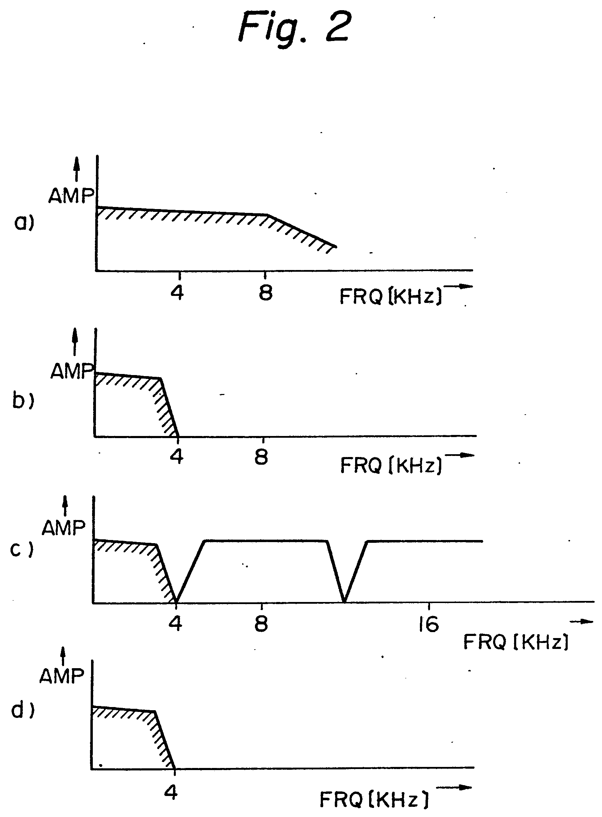

Fig. 2 contains graphs depicting the spectra of signals appearing at portions ⓐ, ⓑ, ⓒ and ⓓ in Fig. 1;

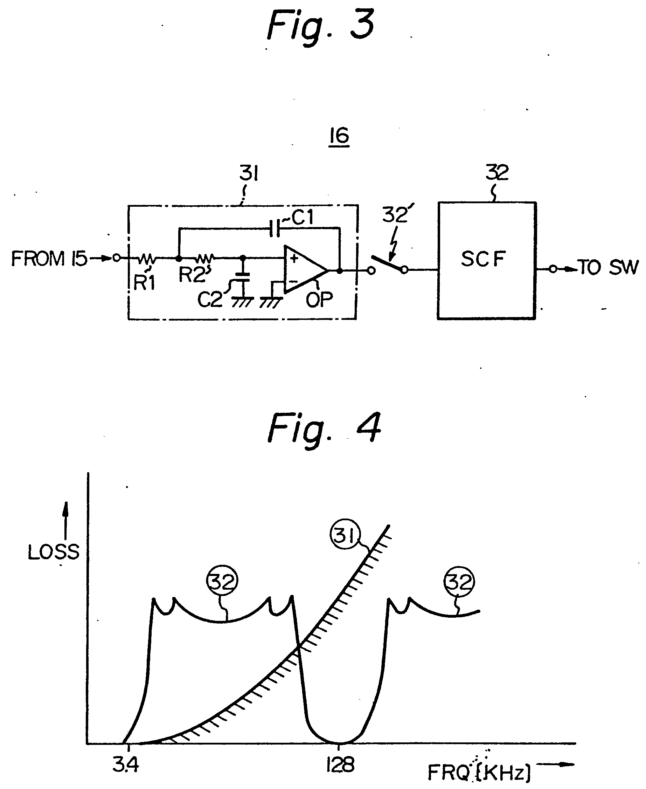

Fig. 3 schematically illustrates a prior filter 16 in Fig. 1;

Fig. 4 is a graph depicting the loss (LOSS) — frequency (FRQ) characteristics of signals obtained by the filter 16 in Fig. 3;

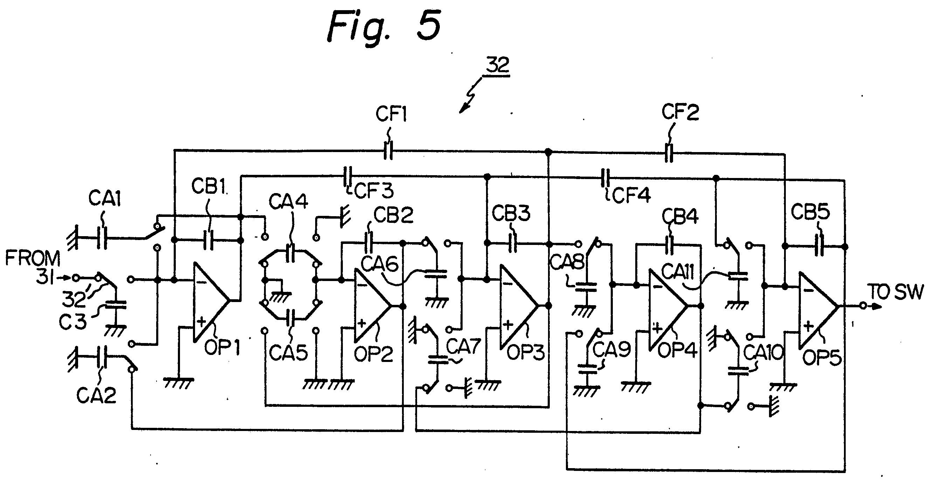

Fig. 5 is a circuit diagram illustrating details of a prior SCF 32 and a switching means 32′ in Fig. 3;

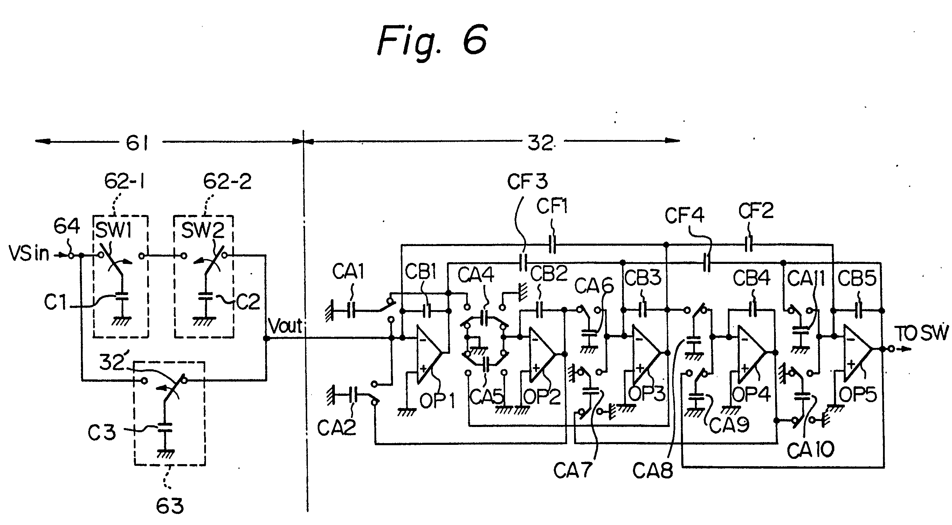

Fig. 6 is a circuit diagram illustrating embodiment according to the present invention;

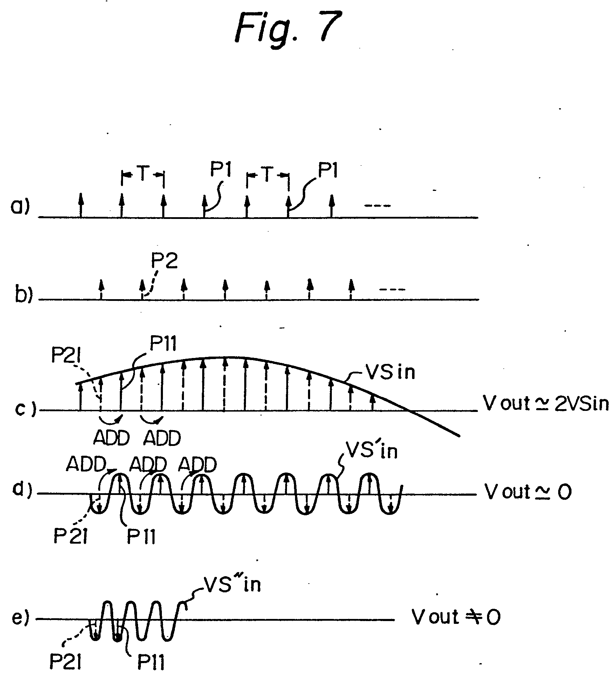

Fig. 7 depicts timing charts used for explaining the operation of a prefilter 61 in Fig. 6;

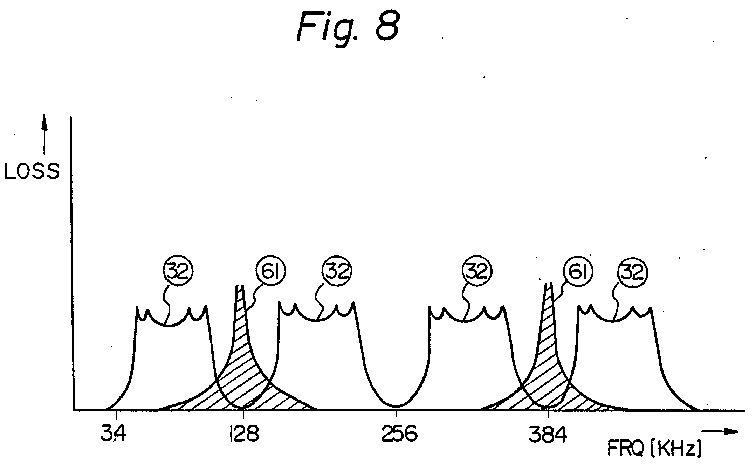

Fig. 8 is a graph depicting loss (LOSS) — frequency (FRQ) characteristics of signals obtained by a prefilter 61 in Fig. 6;

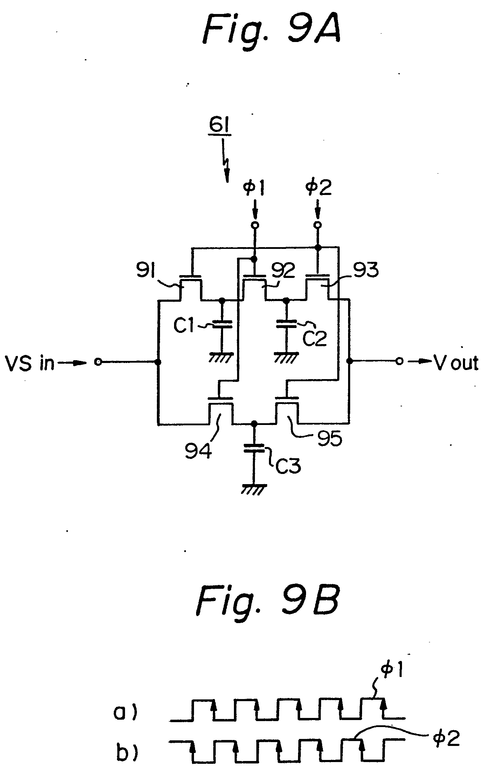

Fig. 9A is a circuit diagram illustrating the actual construction of the prefilter 61 in Fig. 6;

Fig. 9B illustrates waveforms of clock pulses $\varphi 1$ and $\varphi 2$ in Fig. 9A.

In Fig. 1, which is a schematic view of a conventional PCM communication system, the system 10 is divided into a transmitter 11 and a receiver 12. The transmitter 11 and the receiver 12 are connected by way of a transmission line 13. In the transmitter 11, an input voice signal $VS_{in}$ is applied to a transformer 14. The input voice signal is, next, applied to a PCM channel filter (FIL) 16 via a variable attenuator (AV) 15. The variable attenuator 15 operates in such a manner as to adjust the level of the input voice signal. The analogue signal from the filter 16 is converted into a PCM digital voice signal by means of a coder (COD) 17. The coder 17 receives successive sample analogue signals via a switch SW. The switch SW is switched ON and OFF by a frequency of 8 kHz according to a so-called sampling theorem.

In the receiver 12, the PCM digital voice signal is decoded by means of a decoder 17′. The decoded analogue signal, that is, an output voice signal $VS_{out}$, is produced from a transformer 14′ via a filter (FIL) 16′ and a variable attenuator (AV) 15′.

The operation performed in the PCM communication system 10 will now be clarified with reference to Fig. 2. Fig. 2 contains graphs (a), b), c) and d)) with regard to spectra of signals appearing at the portions ⓐ, ⓑ, ⓒ and ⓓ, respectively, in Fig. 1. In each of the graphs a) through d), the ordinate indicates an amplitude (AMP) of the signal and the abscissa indicates the frequency (FRQ) thereof.

The PCM channel filter 16 (Fig. 1) of the transmitter 11 (Fig. 1). operates in such a manner as to cut off signals having a frequency higher than 4 kHz and, accordingly, only voice signals are supplied to the switch SW, as will be understood from the graphs a) and b) of Fig. 2. The filter 16 may comprise an SCF having, at its input stage, a prefilter which eliminates undesired alias signals from voice signals to be transmitted.

In the prior art, the prefilter is mainly comprised of an operational amplifier. Fig. 3 schematically illustrates the prior art filter 16. In this figure, the filter 6 is a combination of a prefilter 31, which is connected to the variable attenuator 15 (Fig. 1), and an SCF 32, which is connected to the coder 17 (Fig. 1). The SCF 32 acts as a low-pass filter and, accordingly, the SCF 32 has loss-frequency characteristics as shown in Fig. 4. Fig. 4 is a graph depicting the loss of signals (LOSS) with respect to the frequency thereof (FRQ). The characteristic curves ㉜ of Fig. 4 correspond to the characteristics of the SCF 32. Referring to both Figs. 3 and 4, since the SCF 32 is driven during the sampling operation by a sampling frequency of 128 kHz by means of a switching means 32′, a so-called attenuation pole can not be created at the frequency of 128 kHz and its neighbouring frequencies between two adjacent curves ㉜. It should be noted that such attenuation pole can also not be created at each of the frequencies 128xn (n=2, 3, 4 ...) and respective neighbouring frequencies. Therefore signals of 128xn±(0 through 4) kHz are not suppressed by the SCF 32. In this case, the signals of (0 through 4) kHz appear, as alias signals, in the base band signal (voice signal), and accordingly, a high quality of voice signal transmission can not be achieved. In order to eliminate the occurrence of the alias signals in the voice signals, the prefilter 31 is very useful. The prefilter 31 produces the loss-frequency characteristic curve ㉛ of Fig. 4. Thus, the attenuation can also be created between two adjacent curves ㉜ by means of the prefilter 31, with the result that no alias signals appear in the voice signals. However, as seen in Fig. 3, since the prefilter 31 is fabricated by the operational amplifier OP, and also, resistors R1, R2 and the capacitors C1, C2, the power consumption becomes large and a high density IC can not be obtained.

In the present invention, the prefilter can be fabricated by employing simple passive electronic elements without employing an operational amplifier.

Preferably, the SCF is driven by first clock pulses having a period T, and samples an input signal supplied to the SCF via the prefilter, wherein the prefilter is comprised of $(2^k-1)$ (k is positive integer) units of switched capacitors, each unit having at least one switched capacitor, and is further comprised of a switched capacitor common to the switched-capacitor filter; the $(2^k-1)$ units of the switched capacitors are driven by second clock pulse groups, each of the second clock pulse having the same period T and the phases of the second clock pulse groups being shifted by $T/2^k$, $2T/2^k$, $3T/2^k$ ... $(2^k-1)T/2^k$ with respect to the first clock pulses; the said switched capacitor common to the switched-capacitor filter is driven by the first clock pulses; each of the said $(2^k-1)$ units of switched capacitors samples and holds the input signal at each corresponding one of the second clock pulse groups successively; all the sampled and held input signals are added to the input signal sampled and held by the said switched capacitor common to said switched-capacitor filter; and the added input signals are all supplied to the switched-capacitor filter synchronously with the first clock pulses.

Fig. 5 is a circuit diagram illustrating details of the prior SCF 32 and the switching means 32' in Fig. 3. The SCF 32 and the switching means 32' act as a low-pass filter having loss-frequency characteristic ㉜ in Fig. 4. Since the SCF 32 itself is not an essential part of the present invention and, also, since the SCF 32 is known from publications, for example, David J. Allstat et al: "Fully-Integrated High-Order NMOS Sampled Data Ladder Filters", ISSCC 78, P. 82, details of the operation of the SCF 32 will not be explained here. In Fig. 5, the reference symbols OP1 through OP5 represent operational amplifiers. These five operational amplifiers construct a five order low-pas SCF. The reference symbols CB1 through CB5 represent integration capacitors. The reference symbols CA1 through CA11 represent switched capacitors acting as resistors. The reference symbols CF1 through CF4 represent feedback capacitors.

In order that the invention may be better understood, an embodiment of the invention will now be described with reference to the accompanying drawings. The prefilter of the present invention preferably comprises $2^k$ units of the switched capacitors, and the case where k=1 is taken as an example.

Fig. 6 is a circuit diagram illustrating an embodiment of the prefilter according to the present invention and also the SCF 32. In Fig. 6, the SCF 32 has, at its input stage, the prefilter 61. When k=1, as previously mentioned, one unit comprising just one newly employed switched capacitor and the pre-existing conventional switched capacitor, that is two $(2^k)$ switched capacitor units, comprise the prefilter. In this case, it may be necessary to use first clock pulses for driving the prefilter and second clock pulses for driving the following low-pass filter, where said first clock pulses are different from said second clock pulses. However, in this Fig. 6, the one unit comprises two newly employed switched capacitors 62—1 and 62—2; thereby both the prefilter and the following low-pass filter can be driven by the same clock pulses. Each of the switched capacitors 62—1 and 62—2 is comprised of a pair of a switching means and a capacitor, such as SW1, C1 and SW2, C2. It should be noted that the switching means 32' and a capacitor C3 is also a switched capacitor 63, which functions as a part of the prefilter 61. However, the switched capacitor 63 is common to the conventional SCF 32. As mentioned above, the switching means 32' is switched ON and OFF by the sampling frequency of 128 kHz, which is the same as the frequency of said clock pulses used for activating the switching means of the SCF 32.

The operation of the prefilter will now be explained with reference to Figs. 6 and 7. The input voice signal $VS_{in}$ via the variable attenuator 15 (Fig. 1) is applied to an input terminal 64. The signal $VS_{in}$ is sampled and held by the switched capacitors 62—1, 62—2 and 63, and transferred to the input of the SCF 32. The switched capacitor 63 which is common to the SCF 32, is driven by first clock pulses P1 having a period T (see row a) of Fig. 7). The switched capacitors 62—1 and 62—2 are driven by both the first clock pulses P1 and also the other clock pulses P2 being shifted in phase by predetermined value (see row b) of Fig. 7).

The switching means SW2 operates in phase with the switching means 32', but, the switching means SW1 operates in opposite phase with respect said switching means SW2 and 32'. The relationship of the phase between these switching means is clarified by the switching conditions thereof shown in Fig. 6.

When an ordinary input voice signal $VS_{in}$ (see curve $VS_{in}$ in row c) of Fig. 7) is applied to the input terminal 64, first, the signal $VS_{in}$ is sampled by the pulse P21 and held in the capacitor C1. Soon after the occurrence of the pulse P21, the capacitor C1 discharges its sampled and held signal $VS_{in}$ to the capacitor C2. Accordingly, the capacitor C2 holds the $VS_{in}$ at the pulse P21. On the other hand, the capacitor C3 samples the signal $VS_{in}$ and holds the signal $VS_{in}$ which has been obtained immediately before the occurrence of the pulse P11. Thereafter, when the pulse P11 occurs, the signals $VS_{in}$ held in the capacitor C2 and the signal $VS_{in}$ held in the capacitor C3 are added and supplied to the input of the SCF 32. Consequently, the sampled signal $VS_{in}$ has an amplitude higher than, by about two times, the amplitude of the sampled signal $VS_{in}$ which is produced in the prior art filter illustrated in Fig. 3. Refer to the expression $V_{out} \simeq 2\, VS_{in}$ in the row c) of Fig. 7. $V_{out}$ is an output voltage at the output of the prefilter 61 in Fig. 6.

When the input voice signal includes the signal $VS'_{in}$ having a frequency of (128—4) kHz through (128+4) kHz (see $VS'_{in}$ in row d) of Fig. 7), the previously mentioned alias signal having a frequency of 0 through 4 kHz appears as a noise signal in the base band signal, that is the ordinary output voice signal VS$_{out}$ (Fig. 1). This is because, as previously explained, the frequency of the signal VS$'_{in}$, that is 128 ± (0 through 4) kHz, substantially coincides with the frequency of the first clock pulse P1, that is 128 kHz, by which pulses P1 the SCF 32 and the switched capacitor 63 are driven. Therefore, the signal VS$'_{in}$ of row d) must be prevented from being supplied to the input of the SCF 32.

The prefilter 61 can easily suppress such signal VS$'_{in}$. The reason for this will now be clarified with reference to row d) of Fig. 7 and also Fig. 6. The operation for processing the signal VS$'_{in}$ is similar to the operation mentioned with reference to row c) of Fig. 7. In other words, the signal VS$'_{in}$, having negative amplitude at the pulse P21, is delayed by the time T/2 and added to the signals VS$'_{in}$, having positive amplitude at the pulse P11. Consequently, these two adjacent signals VS$'_{in}$ appearing at the pulses P21 and P11, cancel each other (see the equation V$_{out}$ ≃ 0 in the row d)). As a result, the signal VS$'_{in}$ is prevented from passing through the SCF 32, and accordingly, no alias signal appear in the base band signal.

The loss-frequency characteristics of signals obtained in the prefilter 61 are indicated in Fig. 8. Fig. 8 is a graph depicting the loss of signal (LOSS) with respect to the frequency thereof (FRQ). The characteristic curves ㉜ are identical to those shown in Fig. 4. However, the characteristic curves ㉖ of the prefilter 61 are very different from the characteristic curve ㉛ shown in Fig. 4 of the prefilter 31 in Fig. 3. Although, the curves ㉖ are different from said curve ㉛, it is apparent from Fig. 8 that the prefilter 61 can also create an attenuation pole at the frequency [128 ± (0 through 4)] kHz.

However, the prefilter 61 has a defect in that it creates the attenuation poles at the frequency of [128×n ± (0 through 4)] kHz, where the positive integer n is limited to an odd number, such as 1, 3, 5, 7 ... This can be seen in Fig. 8, in which, for example, the attenuation pole at the frequency 256 (128×2) and the neighbouring frequencies, is not created. Therefore, the prefilter 61 can not eliminate signals having the frequencies [128×2l ± (0 through 4)] kHz (l is positive integer) from the input voice signal VS$_{in}$. In this case, the alias signals having the frequencies {128×2l — [128×2l ± (0 through 4)]} kHz, may appear in the base band signal. However, such alias signals can easily be suppressed by an appropriate means, without using the prefilter, for example, by a simple and typical RC passive filter which may be located at the input terminal 64 (Fig. 6). Also, such signals have already been suppressed by the transformer 14 (Fig. 1). Thus, it is not necessary for the prefilter 61 to eliminate the signals having the frequencies [128×2l ± (0 through 4)] kHz.

The reason such signals pass through the prefilter 61, may be clarified with reference to row e) of Fig. 7. The signal VS$''_{in}$ of row e) has

the frequency [128×2l ± (0 through 4)] kHz, where l equals to, for example, 1. Since the signals VS$''_{in}$ sampled at the pulses P21 and P11 have the same polarity, these sampled signals do not cancel each other (see the equation Vout ≒ 0 of the row e)).

The prefilter 61 of Fig. 6 may actually be fabricated as illustrated in Fig. 9A. In Fig. 9A, the capacitors C1, C2 and C3 are identical to those of Fig. 6. The switching means SW1 of Fig. 6 is fabricated by FETs (field effect transistors) 91 and 92. The switching means SW2 of Fig. 6 is fabricated by the FET 92 and an FET 93. The FET 92 is common to both of the switching means SW1 and SW2. The switching means 32' of Fig. 6 is fabricated by FETs 94 and 95. The switching operations of the switching means (SW1, SW2, 32') can be performed by applying clock pulses φ1 and φ2 to respective gates of the FETs. The waveforms of the clock pulses φ1 and φ2 are illustrated in rows a) and b) of Fig. 9B, respectively. The arrows shown in row a) correspond to the arrows shown in row a) of Fig. 7. The arrows shown in row b) correspond to the arrows shown in row b) of Fig. 7. When the clock pulses are logic "1" (high) and logic "0" (low), the FETs become conductive and non-conductive, respectively.

In Fig. 9A, when the capacitance value of the capacitor C3 is determined to be C, the capacitance value of the capacitor C1 and also the capacitance value of the capacitor C2 are determined to be 2C, respectively. Accordingly, the capacitance ratios C1/C3 and C2/C3 are equal to 2. When the FET 92 becomes conductive, the capacitors C1 and C2 are connected in series. Then, the half of the terminal voltage of the capacitor C1 develops at the terminal of the capacitor C2. However, since the terminal voltage of the capacitor C2 must be equal to that of the capacitor C3, in order to satisfy the expression V$_{out}$ ≃ 0 in row d) of Fig. 7, the ratios C2/C3 and C1/C3 are determined to be equal to 2.

As mentioned above, according to the present invention, the prefilter (61) can be fabricated merely by simple electronic elements, such as switched capacitors, without using an operational amplifier. Therefore, the power consumption of the band pass filter can be reduced from that in the prior art and, further, a high density IC can be achieved.

**Claim**

A switched capacitor filter device with, at its input, an antialias sampling prefilter (61) which provides the succeeding stage of the filter with a summed signal (VS$_{out}$) at the end of each period (T, Fig. 7) of a predetermined length, the sampling prefilter in each period making and storing at least two samples at different times of an input signal (VS$_{in}$) and combining the stored samples to form the summed signal, the antialias sampling prefilter comprising a plurality of switched capacitors controlled by clock pulses (41, 42) for sampling the input signal and storing the samples, characterized in that the input sampling prefilter (61) comprises first and second switched capacitors (62—1, 62—2), of substantially equal capacitance connected in series, and a third switched capacitor (63) of substantially half the said capacitance connected in parallel with the first and second switched capacitors, the clock pulses (41, 42) driving the first switched capacitor (62—1) in phase opposition to the second (62—2) and third (63) switched capacitors, and the second and third (63) switched capacitors discharging simultaneously into the succeeding stage of the filter.

**Revendication**

Dispositif de filtrage à condensateurs commutés comportant, à son entrée, un préfiltre d'échantillonnage antipseudonyme (61) qui alimente l'étage suivant du filtre avec un signal additionné (VS$_{out}$) à la fin de chaque période (T, figure 7) d'une durée prédéterminée, le préfiltre d'échantillonnage formant et mémorisant au cours de chaque période au moins deux échantillons à des instants différents d'un signal d'entrée (VS$_{in}$) et combinant les échantillons mémorisés pour produire le signal additionné, le préfiltre d'échantillonnage antipseudonyme comprenant plusieurs condensateurs commutés qui sont commandés par des impulsions d'horloge ($\varphi$1, $\varphi$2) pour l'échantillonnage du signal d'entrée et la mémorisation des échantillons, caractérisé en ce que le préfiltre d'échantillonnage d'entrée (61) comprend un premier et un deuxième condensateur commutés (62—1, 62—2) de capacités sensiblement égales connectés en série, et un troisième condensateur commuté (63) de capacité sensiblement égale à la moitié de ladite capacité qui est connecté en parallèle avec les premier et deuxième condensateurs commutés, les impulsions d'horloge ($\varphi$1, $\varphi$2) excitant le premier condensateur commuté (62—1) en opposition de phase avec le deuxième et le troisième condensateur commutés (62—2, 63), et les deuxième et troisième (63) condensateurs commutés se déchargeant simultanément dans l'étage suivant du filtre.

**Patentanspruch**

Umschaltbare Kondensatoren aufweisende Filtervorrichtung mit einem Antiumfalt(anti-alias)-Abtastvorfilter (61) an ihrem Eingang, das die nachfolgende Stufe des Filters mit einem summierten Signal (VS$_{out}$) am Ende jeder Periode (T, Fig. 7) einer vorbestimmten Länge speist, wobei das Abtastvorfilter in jeder Periode wenigstens zwei Abtastungen zu verschiedenen Zeiten eines Eingangssignals (VS$_{in}$) ausführt und diese speichert und die gespeicherten Abtastungen kombiniert, um das summierte Signal zu bilden, und wobei das Artiumfalt-Abtastvorfilter mehrere durch Taktimpulse ($\varphi$1, $\varphi$2) gesteuerte umschaltbare Kondensatoren zum Abtasten des Eingangssignals und zum Speichern der Abtastungen enthält, dadurch gekennzeichnet, daß das Eingangsabtastvorfilter (61) in Reihe geschaltete erste und zweite umschaltbare Kondensatoren (62—1, 62—2) mit im wesentlichen gleicher Kapazität und einen parallel zu den ersten und den zweiten umschaltbaren Kondensatoren geschalteten dritten umschaltbaren Kondensator (63) mit im wesentlichen der halben Kapazität enthält, wobei die Taktimpulse ($\varphi$1, $\varphi$2) den ersten umschaltbaren Kondensator (62—1) in entgegengesetzter Phase zu dem zweiten (62—2) und dritten (63) umschaltbaren Kondensator ansteuern und der zweite und der dritte (63) umschaltbare Kondensator gleichzeitig die nachfolgende Stufe des Filters entladen.

# Fig. 1

# Fig. 2

*Fig. 3*

*Fig. 4*

# Fig. 5

# Fig. 6

# Fig. 7

a)

b)

c)   Vout ≃ 2VSin

d)   Vout ≃ 0

e)   Vout ≒ 0

# Fig. 8

# Fig. 9A

# Fig. 9B